# EUROPÄISCHE PATENTSCHRIFT

(11) **EP 0 416 165 B1**
(45) Veröffentlichungstag und Bekanntmachung des Hinweises auf die Patenterteilung: **14.12.1994**
(21) Anmeldenummer: 89116664.7
(22) Anmeldetag: 08.09.1989
(51) Int. Cl.: H01L 21/60, H01L 21/90

(54) **Verfahren zur globalen Planarisierung von Oberflächen für integrierte Halbleiterschaltungen**
Method for the global planarisation of surfaces for integrated semiconductor circuits
Procédé d' aplanissement global de surfaces pour circuits semi-conducteurs integrés

(43) Veröffentlichungstag der Anmeldung: 13.03.1991
(73) Patentinhaber: SIEMENS AKTIENGESELLSCHAFT, 80333 München (DE)
(72) Erfinder: Grewal, Virinder, Dr.-Ing., D-8017 Ebersberg (DE); Menz, Klaus-Dieter, Dipl.-Ing., D-8000 München 80 (DE); Huber, Ronald, Dr.rer.nat., D-8011 Hohenbrunn (DE)

(56) Entgegenhaltungen:
- EP-A- 0 312 154
- US-A- 4 662 064
- IEEE TRANSACTIONS ON SEMICONDUCTOR MANUFACTURING, Band 1, Nr. 4, November 1988, Seiten 140-145, IEEE, New York, US; D.J. SHELDON et al.: "Application of a two-layer planarization process to VLSI intermetal dielectric and trench isolation processes"
- "The Chemistry of the Semiconductor Industry", Ed. S.J. MOSS und A. LEDWITH, 1987, Blackie, London, GB

## Beschreibung

Die Erfindung betrifft ein globales Planarisierungsverfahren für Oberflächen von integrierten Schaltungen, wobei eine lokal planarisierte Oxidschicht unter Verwendung einer Phototechnik und einer planarisierenden Hilfsschicht zurückgeätzt wird.

Ein ähnliches Verfahren ist beispielsweise aus einem Bericht von D. J. Sheldon et. al. aus dem IEEE Transaction on Semiconductor Manufacturing, Vol. 1, No. 4, Nov. 1988, Seiten 140 bis 145 zu entnehmen, bei dem als planarisierende Hilfsschicht Photolack verwendet wird.

Die stets größer werdende Packungsdichte bei VLSI (= very large scale integration)-Schaltungen erfordert in zunehmendem Maße eine globale Planarisierung. Mit steigender Anzahl der verwendeten Ebenen nehmen die einzuebnenden Stufen deutlich zu, was unter anderem zu Abrissen bzw. Kurzschlüssen in der Metallisierung und zu Focustiefenproblemen bei den hier verwendeten Wafer-Steppern führt.

Bisher gibt es kein für die Fertigung geeignetes Verfahren, eine sich über die gesamte Wafer-/Chip-Oberfläche erstreckende Planarisierung (= globale Planarisierung) durchzuführen.

Außer der eingangs erwähnten Photolacktechnik (Sheldon-Bericht) sind aus einem Bericht von A. C. Adams und C. D. Capio aus J. Electrochem. Soc.: Solid State Science and Technology, Februar 1981, Seiten 423 bis 429 Planarisierungsprozesse für phosphordotierte Siliziumoxid-Schichten mit Hilfsschichten aus zum Beispiel Positivphotolack und Rückätzen bekannt, die zwar gute Planarisierungsergebnisse bringen, aber keine globale Planarisierung. Typische Abklinglängen für solche Lackrückätztechniken liegen im Bereich von 10 µm.

Das gleiche gilt auch für ein Planarisierungsverfahren, wie es als Poster auf der DAGV-Tagung "Trends and New Applications in Thin Films" (TATF) vom 27.02.1989 bis 03.03.1989 in Regensburg (to be published in "Thin Films", Oktober 1989) von O. Spindler und B. Neureither vorgetragen worden ist. Bei dem dort gezeigten Planarisierungsverfahren unter Verwendung einer Precision 5000 von Applied Materials, mit welcher Abscheidung und Rückätzen von Siliziumoxid in der gleichen Anlage erfolgt, treten Abklinglängen von 4 µm auf.

Desweiteren ist ein globales Planarisierungsverfahren bekannt, das auf dem mechanischen Schleifen von Oxidschichten beruht, was eine zusätzliche Schleifeinrichtung erfordert. Ebenso gibt es Einebnungsmethoden die zusätzliche Dummy-Metall- bzw. Oxidbahnen verwenden.

Aus einem Bericht von M. Kawai et. al. aus dem Conf. Band der V-MIC Konferenz 13./14. Juni 1988, Seiten 419 bis 425 ist schließlich das Spin-On-Glas als Material für Planarisierungsprozesse bekannt.

Aufgabe der Erfindung ist es, die Nachteile der geschilderten bekannten Prozesse zu vermeiden und insbesondere ein Planarisierungsverfahren anzugeben, welches eine globale Planarisierung unter Verwendung von bekannten und fertigungstechnisch bewährten Vorrichtungen erlaubt.

Diese Aufgabe wird erfindungsgemäß durch den Ablauf der folgenden Verfahrensschritte gelöst:
a) Durchführung einer lokalen Planarisierung, wobei ausgehend von den bis zu der strukturierten, einzuebnenden Schicht mit einer darunterliegenden Trägerebene fertiggestellten Bauelement zunächst eine lokal planarisierte Siliziumoxid-Schicht erzeugt wird, wobei die Siliziumoxid-Restdicke d₂ auf allen von der strukturgebenden Ebene nicht bedeckten Gebieten nach der lokalen Planarisierung größer ist, als die Stufenhöhe d₁ der Struktur,
b) Durchführung einer Phototechnik, bei der invers zur lokal planarisierten Ebene Photolackstrukturen erzeugt werden, deren Breite kleiner ist als die Breite der durch die Struktur bedingten Oxidgräben,
c) Erzeugen einer planarisierenden Hilfsschicht dadurch, daß auf die so erzeugte Anordnung eine gut haftende und planarisierende Hilfsschicht aufgebracht wird, die in Abhängigkeit des nachfolgenden anisotropen Rückätzens so gewählt wird, daß ihre Ätzrate größer als die des Photolackes und annähernd gleich der der Siliziumoxidschicht ist,
d) Durchführung eines anisotropen Rückätzprozesses, wobei der Dickenabtrag so gewahlt wird, daß die Oxidoberfläche auf den Strukturgebieten dem Niveau nichtrückgeätzten Oxides unter den Lackflächen annahernd entspricht,
e) Entfernung des Photolackes und anschließend Entfernung der Hilfsschichtreste dadurch, daß nach dem Lackentfernen die Oberfläche durch eine isotrope Ätzung überätzt wird, wobei die durch die anisotrope Ätzung entstandene Damage-Schicht zusätzlich entfernt wird.

Die Kombination dieser einzelnen Verfahrensschritte erlaubt eine gute Fertigbarkeit ohne hohen Kontrollaufwand.

Durch das Verfahren nach der Lehre der Erfindung ist die Möglichkeit gegeben, höchstintegrierte Halbleiterschaltungen mit vielen strukturgebenden Ebenen herzustellen.

Es liegt im Rahmen der Erfindung, als einzuebnende strukturierte Ebenen eine Metallisierungsebene oder eine polykristalline Siliziumebene zu verwenden und im Anschluß an Verfahrensschritt e) eine Siliziumoxidschicht bis zur gewünschten Isolatordicke d₃ aufzubringen. Es ist aber auch möglich, als einzuebnende strukturierte Ebene eine mit Gräben in der Oberfläche versehene Trägerebene zu verwenden (sogenannte Shallow Trench Ebene). Dabei wird der Dickenabtrag bei der anisotropen Rückätzung so weit geführt, bis die Strukturoberflächen freigeätzt sind.

Die anschließende Überätzung entfällt dann.

Weitere Ausgestaltungen der Erfindung ergeben sich aus den Unteransprüchen.

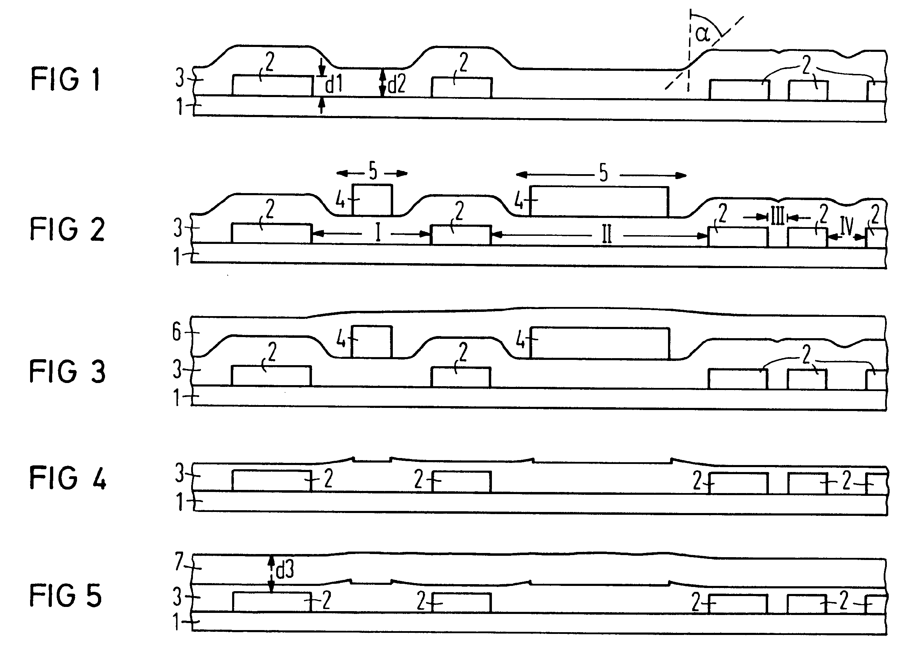

Anhand der Figuren 1 bis 5 sollen weitere Einzelheiten der Erfindung näher erläutert werden. Dabei zeigen
- die Figuren 1 bis 5: in schematischer Darstellung die erfindungswesentlichen Verfahrensschritte bei einem auf eine strukturgebende Ebene erfolgenden Planarisierungsprozeß mit Plasmaoxid.

In allen Figuren sind gleiche Teile mit gleichen Bezugszeichen bezeichnet.

Figur 1: Mit dem Bezugszeichen 2 ist die auf der Trägerebene 1 liegende zu isolierende und einzuebnende strukturierte Schicht, die beispielsweise aus Aluminium bestehend kann, bezeichnet. Die lokale Planarisierung kann zum Beispiel im Falle der bereits erwähnten AMT Precision 5000-Anlage folgendermaßen erreicht werden:
1) Ganzflächige, konforme, durch Zersetzung von Tetraäthylorthoslikat im Plasma abgeschiedene Siliziumoxidschicht.
2) Ätzung zur Abschrägung der Oxidflanken.
3) 2. Oxidabscheidung.
4) Rückätzen des Oxides auf die Solldicke.

Als Resultat dieser Prozeßsequenz erhält man das Oxid 3. Die Siliziumoxid-Restdicke d₂ nach der lokalen Planarisierung muß auf allen von der strukturgebenden Ebene nicht bedeckten Gebieten größer sein, als die Stufenhöhe d₁ der Struktur (2). Der in der Figur eingezeichnete Flankenwinkel α ist ein Maß für die erreichte Planarisierung.

Figur 2: Invers zur lokal planarisierten Ebene 2 werden nun Photolackstrukturen 4 erzeugt. Sie dienen bei der anisotropen Ätzung (siehe Figur 4) zur Maskierung des in den Gräben tiefliegenden Oxides. Dabei muß beachtet werden, daß bedingt durch die lokale Planarisierung (siehe Figur 1) eine Lackabdeckung bei schmalen Spalten, wie sie bei III und IV, vorliegen im Gegensatz zu den breiteren Spalten I und II nicht erfolgen darf. In die Berechnung der kritischen Spaltbreite, ab der eine Lackabdeckung erfolgt, gehen unter anderem Strukturdicke, Oxidrestdicke nach der lokalen Planarisierung, Flankenwinkel α, minimale Lackstegbreite der Hilfsebene (4), sowie die Justier- und Maßtoleranzen der verwendeten Technologie ein. Durch die Verwendung eines entsprechenden Vorhalts bei der Photolacktechnik (4) wird gewährleistet, daß der Lack nicht die Oxidflanken bedeckt, da ansonsten nach der anisotropen Rückätzung Oxidhöcker zurückbleiben würden. Der Vorhalt berechnet sich aus den gleichen oben genannten technischen Daten.

Spalte, die nicht durch die lokale Planarisierung aufgefüllt werden, aber unterhalb der kritischen Spaltbreite liegen, werden durch die nachfolgende Planarisierung (Figur 4) weitestgehend eingeebnet. Für gängige 1 µm CMOS-Logik-Prozesse unter Verwendung einer lokalen Planarisierung mit der Precision 5000 hat man bei Metallisierungsebenen mit kritischen Spaltbreiten im Bereich von 5 µm zu rechnen.

Figur 3: Nach dem Erzeugen der Photolackbahnen 4 wird eine gut haftende und planarisierende Hilfsschicht 6, zum Beispiel aus Spin-On-Glas bestehend, aufgebracht. Besteht diese Hilfsschicht nicht aus Spin-On-Glas, so ist bei der Auswahl eines anderen Materials auch darauf zu achten, daß die Ätzrate dieser Hilfsschicht in Abhängigkeit des folgenden anisotropen Rückätzens größer als die des Photolackes 4 und annäherend gleich der der Siliziumoxidschicht 3 ist.

Figur 4: Die so erhaltene Schichtfolge wird nun anisotrop zum Beispiel in einer AME-HEX-Mehrscheibenätzanlage (Fa. Applied Materials Equipment) soweit zurückgeätzt, daß die Oxidoberfläche auf den Strukturgebieten 2 dem Niveau des nicht rückgeätzten Oxides unter den Lackflächen 4 annähernd entspricht. Eine solche Ätzung kann zum Beispiel mit Festzeit (ohne Endpunkterkennung) erfolgen. Durch die annähernd gleichen Ätzraten von Oxid 3 und Hilfsschicht 6 und geringeren Ätzraten des Lackes 4 verbleiben nach der Rückätzung noch Photolackreste. Vorzugsweise wird die anisotrope Ätzung mit Trifluormethan und Sauerstoff und/oder Argon durchgeführt.

Figur 5: Nach dem Entfernen des Photolackes, zum Beispiel durch Lackveraschung in einem Barrel- oder Downstream-Verascher, wird die nun lackfreie Oberfläche überätzt. Die Überätzung, eine isotrope Naß- bzw. Trockenätzung, dient zur Entfernung noch vorhandener Hilfsschichtreste und der durch die anisotrope Ätzung entstandenen Damage-Schicht. Der Oxidätzabtrag von 3 liegt zum Beispiel typischerweise unter 50 nm. Abschließend wird eine weitere Siliziumoxid-Schicht 7 zur Einstellung der durch die Technologie vorgegebenen Zieldicke d₃ abgeschieden. Im Falle der Grabenplanarisierung entfällt das Überätzen (siehe Figur 4) und die Abscheidung des Isolationsoxids.

## Patentansprüche

1. Globales Planarisierungsverfahren für Oberflächen von integrierten Schaltungen, wobei eine lokal planarisierte Oxidschicht unter Verwendung einer Phototechnik und einer planarisierenden Hilfsschicht zurückgeätzt wird, mit den folgenden Verfahrensschritten:
a) Durchführung einer lokalen Planarisierung, wobei ausgehend von dem bis zu einer strukturierten, einzuebnenden Schicht (2) mit einer darunterliegenden Trägerebene (1) fertiggestellten Bauelement zunächst eine lokal planarisierte Siliziumoxidschicht (3) erzeugt wird, wobei die Siliziumoxidrestdicke d₂ auf allen von der strukturgebenden Ebene nichtbedeckten Gebieten nach der lokalen Planarisierung größer ist als die Stufenhöhe d₁ der Struktur (2),
b) Durchführung einer Phototechnik, bei der invers zur lokal planarisierten Ebene (2) Photolackstrukturen (4) erzeugt werden, deren Breite kleiner ist als die Breite der durch die Struktur bedingten Oxidgräben (5),
c) Erzeugen einer planarisierenden Hilfsschicht dadurch, daß auf die so erzeugte Anordnung eine gut haftende und planarisierende Hilfsschicht (6) aufgebracht wird, die in Abhängigkeit des nachfolgenden anisotropen Rückätzens so gewählt wird, daß ihre Ätzrate größer als die des Photolackes (4) und annähernd gleich der der Siliziumoxidschicht (3) ist,
d) Durchführung eines anisotropen Rückätzprozesses, wobei der Dickenabtrag so gewählt wird, daß die Oxidoberfläche auf den Strukturgebieten (2) dem Niveau des nichtrückgeätzten Oxides (3) unter den Lackflächen (4) annähernd entspricht,
e) Entfernung des Photolackes und anschließend Entfernung der Hilfsschichtreste dadurch, daß nach dem Lackentfernen die Oberfläche durch eine isotrope Ätzung überätzt wird, wobei eine durch die anisotrope Ätzung entstandene Damage-Schicht zusätzlich entfernt wird.

2. Verfahren nach Anspruch 1, **dadurch** **gekennzeichnet**, daß als einzuebnende strukturierte Ebene (2) eine Metallisierungsebene verwendet wird und im Anschluß an Verfahrensschritt e) eine Siliziumoxidschicht (7) bis zur gewünschten Isolatordicke d₃ aufgebracht wird.

3. Verfahren nach Anspruch 2, **dadurch** **gekennzeichnet**, daß als einzuebnende strukturierte Ebene (2) anstelle einer Metallisierungsebene eine polykristalline Siliziumebene verwendet wird.

4. Verfahren nach Anspruch 1, **dadurch** **gekennzeichnet**, daß als einzuebnende strukturierte Ebene (2) eine mit Gräben in der Oberfläche versehene Trägerebene verwendet wird und in Abänderung des Verfahrens nach Anspruch 1 im Verfahrensschritt d) der Dickenabtrag bei der anisotropen Rückätzung so weit geführt wird, bis die Strukturoberflächen (2) freigeätzt sind und im Verfahrensschritt e) die Überätzung entfällt.

5. Verfahren nach einem der Ansprüche 1 bis 3 **dadurch gekennzeichnet**, daß die aus Siliziumoxid bestehenden Isolationsschichten (3, 7) durch einen plasmaunterstützten Prozeß aus der Gasphase abgeschieden werden.

6. Verfahren nach einem der Ansprüche 1 bis 5, **dadurch gekennzeichnet**, daß als gut haftende und planarisierende Hilfsschicht (6) nach Verfahrensschritt c) Spin-On-Glas verwendet wird, welches durch Aufschleudern auf die Schichtenfolge (1, 2, 3, 4) aufgebracht wird.

7. Verfahren nach einem der Ansprüche 1 bis 6, **dadurch gekennzeichnet**, daß der anisotrope Rückätzprozeß nach Verfahrensschritt d) so durchgeführt wird, daß sich die Ätzraten Spin-On-Glas (6) zu Plasmaoxid (3) zu Photolack (4) wie 1 zu 0.8 bis 1.2 zu größer 1.5 verhalten.

8. Verfahren nach Anspruch 7, **dadurch** **gekennzeichnet**, daß der Ätzprozeß unter Verwendung von Trifluormethan (CHF₃) und Sauerstoff und/oder Argon durchgeführt wird.

## Claims

1. Overall planarization method for surfaces of integrated circuits, in which a locally planarized oxide layer is back-etched using a photolithographic procedure and a planarizing auxiliary layer, comprising the following method steps:
a) performance of a local planarization, in which, starting from the component which has been completed up to a patterned layer (2) which is to be planarized and has an underlying substrate level (1), a locally planarized silicon oxide layer (3) is first created, the silicon oxide residual thickness d₂ being greater than the step height d₁ of the pattern (2) on all the regions not covered by the pattern-providing level after the local planarization,
b) performance of a photolithographic procedure, in which photoresist patterns (4), whose width is smaller than the width of the oxide trenches (5) due to the pattern, are created inversely with respect to the locally planarized level (2),
c) creation of a planarizing auxiliary layer by applying, to the arrangement produced in this way, a planarizing auxiliary layer (6) which has good adhesion and which is chosen as a function of the subsequent anisotropic back-etching so that its etching rate is greater than that of the photoresist (4) and is approximately equal to that of the silicon oxide layer (3),
d) performance of an anisotropic back-etching process, in which the chosen thickness removal is such that the oxide surface on the pattern regions (2) is approximately equal to the level of the non-back-etched oxide (3) underneath the resist areas (4),
e) removal of the photoresist and, subsequently, removal of the auxiliary layer residues by over-etching the surface by means of isotropic etching after the resist has been removed, a damaged layer produced by the anisotropic etching being additionally removed.

2. Method according to Claim 1, characterized in that a metallizing level is used as patterned level (2) to be planarized and, subsequent to method step e), a silicon oxide layer (7) is applied up to the desired insulator thickness d₃.

3. Method according to Claim 2, characterized in that a polycrystalline silicon level is used as patterned level (2) to be planarized instead of a metallizing level.

4. Method according to Claim 1, characterized in that a substrate plane provided with trenches in the surface is used as patterned level (2) to be planarized and, as a departure from the method according to Claim 1, the thickness removal during the anisotropic back-etching in method step d) is conducted until the pattern surfaces (2) are laid bare and the over-etching in method step e) is unnecessary.

5. Method according to one of Claims 1 to 3, characterized in that the insulation layers (3, 7) comprising silicon oxide are deposited from the gas phase by a plasma-assisted process.

6. Method according to one of Claims 1 to 5, characterized in that spin-on glass is used as planarizing auxiliary layer (6) according to method step c) which has good adhesion and which is applied to the layer sequence (1, 2, 3, 4) by spinning-on.

7. Method according to one of Claims 1 to 6, characterized in that the anisotropic back-etching process according to method step d) is performed in such a way that the spin-on glass (6)/plasma oxide (3)/photoresist (4) etching rates are as 1/0.8 to 1.2/greater than 1.5.

8. Method according to Claim 7, characterized in that the etching process is carried out using trifluoromethane (CHF₃) and oxygen and/or argon.

## Revendications

1. Procédé global de planarisation pour des surfaces de circuits intégrés, selon lequel on réalise une rétrocorrosion d'une couche d'oxyde planarisée localement, moyennant l'utilisation d'une technique photochimique et d'une couche auxiliaire de planarisation, comportant les étapes opératoires suivantes :
a) exécution d'une planarisation locale, pour laquelle, à partir du composant formé jusqu'à une couche structurée (2) devant être aplanie et au-dessous de laquelle est situé un plan de support (1), on forme tout d'abord une couche d'oxyde de silicium (3) planarisée localement, l'épaisseur résiduelle d₂ de l'oxyde de silicium sur toutes les régions, non recouvertes par le plan déterminant la structure, étant supérieure, après la planarisation locale, à la hauteur d₁ de la partie étagée de la structure (2),
b) mise en oeuvre d'une technique photochimique, lors de laquelle on forme, d'une manière inverse au plan (2) planarisé localement, des structures de photolaque (4), dont la largeur est inférieure à la largeur des sillons d'oxyde (5) imposés par la structure,
c) production d'une couche auxiliaire de planarisation par le fait que sur le dispositif ainsi obtenu, on dépose une couche auxiliaire (6), qui adhère bien et réalise une planarisation, et que l'on choisit, en fonction de la rétrocorrosion anisotrope suivante, de telle sorte que la vitesse de corrosion dans cette couche auxiliaire est supérieure à la vitesse de corrosion dans la photolaque (4) et est approximativement égale à la vitesse de corrosion dans la couche d'oxyde de silicium (3),
d) exécution d'un processus de rétrocorrosion anisotrope, dans lequel on choisit la réduction d'épaisseur de manière que la surface d'oxyde sur les régions (2) de la structure corresponde approximativement au niveau de l'oxyde (3), qui n'a pas subi la rétrocorrosion, au-dessous des surfaces de laque (4),
e) élimination de la photolaque, puis élimination des restes de la couche auxiliaire grâce au fait qu'après l'élimination de la laque, on corrode de façon excessive la surface au moyen d'une corrosion isotrope, en éliminant en supplément une couche d'endommagement, apparue sous l'effet de la corrosion anisotrope.

2. Procédé suivant la revendication 1, caractérisé par le fait qu'on utilise un plan de métallisation comme plan structuré (2) devant être aplani et qu'à la suite de l'étape opératoire e), on dépose une couche d'oxyde de silicium (7) jusqu'à l'obtention de l'épaisseur désirée d₁ de l'isolant.

3. Procédé suivant la revendication 2, caractérisé par le fait qu'on utilise comme plan structuré (2) devant être aplani, non pas un plan de métallisation, mais un plan de silicium polycristallin.

4. Procédé suivant la revendication 1, caractérisé par le fait qu'on utilise comme plan structuré (3) devant être aplani, un plan de support comportant des sillons dans sa surface, et, à titre de modification du procédé selon la revendication 1, lors de l'étape opératoire d), on réalise la réduction d'épaisseur lors de la rétrocorrosion anisotrope au point que les surfaces (2) de la structure sont mises à nu par corrosion et que, lors de l'étape opératoire e), on supprime l'opération de corrosion excessive.

5. Procédé suivant l'une des revendications 1 à 3, caractérisé par le fait qu'on dépose les couches isolantes (3,7), constituées d'oxyde de silicium, au moyen d'un processus à partir de la phase gazeuse, d'une manière assistée à l'aide d'un plasma.

6. Procédé suivant l'une des revendications 1 à 5, caractérisé par le fait qu'après l'étape opératoire c), on utilise, en tant que couche auxiliaire (6) qui adhère bien et réalise la planarisation, du verre Spin-On, qu'on dépose par centrifugation sur la suite de couches (1,2,3,4,5).

7. Procédé suivant l'une des revendications 1 à 6, caractérisé par le fait qu'on exécute le processus de rétrocorrosion anisotrope de l'étape opératoire d) de manière que les rapports de la vitesse de corrosion du verre Spin-On (6) à la vitesse de corrosion de l'oxyde plasmatique (1) et à la vitesse de corrosion de la photolaque (4) se comportent comme de 1 à 0,8 par rapport à 1,2 jusqu'à plus de 1,5.

8. Procédé suivant la revendication 7, caractérisé par le fait que le processus de corrosion est exécuté moyennant l'utilisation de trifluorométhane (CHF₃) et d'oxygène et/ou d'argon.
